# EUROPEAN PATENT APPLICATION

(11) **EP 3 496 119 A1**
(43) Date of publication of application: **12.06.2019**
(21) Application number: 17205888.5
(22) Date of filing: 07.12.2017
(51) Int. Cl.: H01G 4/008, H01L 49/02, H01G 4/08, H01G 4/20, H01G 4/33, H01L 21/02

(54) **CAPACITOR COMPRISING METAL NANOPARTICLES**

(71) Applicant: IMEC vzw, 3001 Leuven (BE)
(72) Inventor: POPOVICI, Mihaela Ioana, 3001 Leuven (BE)
(74) Representative: DenK iP

(57) **Abstract**

In a first aspect, the present invention relates to a method for making a capacitor, comprising:
a. providing a first electrode (110),
b. providing a first dielectric layer (210) over the first electrode (110),
c. providing a layer (300) of metal nanoparticles (310) over the first dielectric layer (210),
d. completely covering the metal nanoparticles (310) with a further dielectric layer (220),
e. optionally, repeating steps c to d one or more times, and
f. providing a second electrode (120) over the further dielectric layer (220);
wherein a concentration of the metal nanoparticles (310) within each layer (300) of metal nanoparticles (310) is from 0.05 to 1.5 times a percolation threshold, preferably from 0.1 to 1.3 times, yet more preferably from 0.5 to 1.2 times, most preferably from 0.9 to 1.1 times.

## Description

### Technical field of the invention

The present invention relates to the field of capacitors for uses in semiconductor devices. More in particular, it relates to methods for increasing the dielectric constant of a dielectric material in a capacitor.

### Background of the invention

A key role in dynamic random-access memory (DRAM) technology is played by the metal-insulator-metal (MIM) capacitors. According to the 2013 edition of the International Technology Roadmap for Semiconductors (ITRS), a downscaling of the dielectric (i.e. insulator) layer's physical thickness (t_{phys}) to about 6 nm by 2018 and 5 nm by 2020 is forecasted. This roadmap further foresees an upper limit of the leakage current density (Jg) of 1.2 × 10⁻⁷ A/cm² and 1.6 × 10⁻⁷ A/cm² measured at +/-1V, for 2018 and 2020 respectively, while maintaining a 20 fF/cell capacitance level.

A common figure of merit in DRAM technology is the electrical performance of the dielectric material as compared to SiO₂ known as the effective oxide thickness (EOT), which can be calculated as 3.9*t_{phys}/k, wherein k is the dielectric constant. Particularly as the physical thickness has to be downscaled to 5 nm, there are no suitable dielectric materials known up to now that can fulfil the requirements of EOT corresponding to the above-mentioned roadmap objectives for physical thickness and leakage current density, namely an EOT of 0.40 nm or lower. For such low physical thickness, the leakage current specification may be reached if the bandgap of the dielectric is larger than 5 eV, preferably larger than 6 eV. However, the dielectric constant (k) of the known high bandgap dielectrics, typically around 10 to 35, is too low to reach the EOT target specification. For this reason, a dielectric constant of at least 40 would be preferred, more preferably at least 50 or 60.

One way to increase the dielectric constant of a dielectric in a capacitor is disclosed in US7244999 B2 as related art. The method comprises dispersing metal fine particles having a diameter of from 0.1 to 1 µm in a dielectric material and subsequently using said mixture as the material for a dielectric layer between a pair of electrodes in a capacitor. However, the proposed dielectric layer is considerably thick (preferably 0.1 to 100 µm) and the proposed method cannot be downscaled to dielectric layers having a thickness of 20 nm or less in an obvious way.

There is thus still a need in the art for a way to obtain high bandgap dielectrics with high dielectric constants.

### Summary of the invention

It is an object of the present invention to provide good methods for increasing the dielectric constant of a material in a capacitor and good capacitors obtained using said methods. The above objective is accomplished by methods and devices according to the present invention.

It is an advantage of embodiments of the present invention that a dielectric layer in the capacitor may be relatively thin, e.g. 6 nm or lower.

It is an advantage of embodiments of the present invention that the effective oxide thickness may be low, e.g. 0.40 nm or lower.

It is an advantage of embodiments of the present invention that the leakage current density through the dielectric layers may be low, e.g. 1.6 × 10⁻⁷ A/cm² or lower measured at +/-1V.

It is an advantage of embodiments of the present invention that the method does not require high annealing temperatures.

In a first aspect, the present invention relates to a method for making a capacitor, comprising:
a. providing a first electrode,
b. providing a first dielectric layer over the first electrode,
c. providing a layer of metal nanoparticles over the first dielectric layer,
d. completely covering the metal nanoparticles with a further dielectric layer,
e. optionally, repeating steps c to d one or more times, and
f. providing a second electrode over the further dielectric layer;
wherein a concentration of the metal nanoparticles within each layer of metal nanoparticles is from 0.05 to 1.5 times a percolation threshold, preferably from 0.1 to 1.3 times, more preferably from 0.5 to 1.2 times, yet more preferably from 0.9 to 1.1 times, and most preferably from 0.90 to 0.99.

In a second aspect, the present invention relates to a method for forming a memory device comprising making a capacitor by the method according to any embodiment of the first aspect.

In a third aspect, the present invention relates to a capacitor, comprising:
i. a first electrode,
ii. a first dielectric layer over the first electrode,
iii. one or more composite layers on top of each other over the first dielectric layer, each composite layer comprising:
   - a layer of metal nanoparticles obtained by growing them on the layer directly underlying them,
   - a further dielectric layer completely covering the metal nanoparticles, and
iv. a second electrode over the one or more composite layers;
wherein a concentration of the metal nanoparticles within each layer of metal nanoparticles is from 0.05 to 1.5 times a percolation threshold, preferably from 0.1 to 1.3 times, more preferably from 0.5 to 1.2 times, yet more preferably from 0.9 to 1.1 times, and most preferably from 0.90 to 0.99.

In a fourth aspect, the present invention relates to a memory device comprising a capacitor according to any embodiment of the third aspect.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

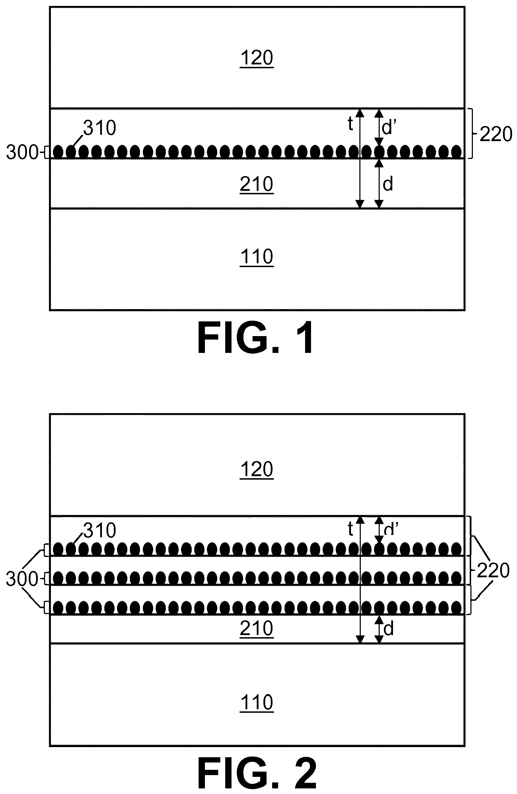

Figs. 1 to 3 are schematic representations of capacitors in accordance with exemplary embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practised without these specific details. In other instances, well-known methods, structures and techniques have not been shown in detail in order not to obscure an understanding of this description.

The following terms are provided solely to aid in the understanding of the invention.

As used herein, and unless otherwise specified, the percolation threshold is a critical concentration value for nanoparticles in a composite formed of metal nanoparticles in a dielectric matrix at which the dielectric constant of the composite takes a maximal value. Within the present invention, the percolation threshold can be determined by plotting the dielectric constant of the composite vs the concentration of nanoparticles and taking the concentration value corresponding to the maximal dielectric constant. For instance, the concentration value may be an area concentration in at/cm² as determined by Rutherford backscattering spectroscopy. The units used to characterise the concentration in nanoparticles corresponding to the percolation threshold are not critical. The physical reality of a nanoparticle concentration corresponding to 0.90 times the percolation threshold is the same whether the percolation threshold is measured in at/cm² or in other units. For instance, the percolation threshold within each assembly consisting of a layer of metal nanoparticles (as provided in step c) and a further dielectric layer (as provided in step d) can be measured in atomic percentage of the metal nanoparticles in the assembly. Concentrations in at% can be determined for instance by a) measuring the concentration Cₙ in at/cm² corresponding to one deposition cycle for the nanoparticles; b) measuring the concentration C_{d} in at/cm² corresponding to one deposition cycle for the further dielectric layer; and calculating Nₙ*Cₙ/(Nₙ*Cₙ+N_{d}*C_{d}) wherein Nn and Nd are the number of deposition cycles for the nanoparticles and the further dielectric respectively. If a percolation threshold determined by plotting the dielectric constant versus concentrations determined by this method is 2.0 at%, 0.90 times the percolation threshold will correspond to 1.8 at%.

As used herein, and unless otherwise specified, the term '*metal*' is not limited to metallic elements and metallic alloys, but comprises also metallic compounds (e.g. RuO₂ or TiN). Alternatively, in the present invention, the term '*metal*' can be substituted by 'material having a resistivity of at most 10⁻⁶ ohm.m, preferably at most 10⁻⁷ ohm.m.

In a first aspect, the present invention relates to a method for making a capacitor, comprising:
a. providing a first electrode,
b. providing a first dielectric layer over the first electrode,
c. providing a layer of metal nanoparticles over the first dielectric layer,
d. completely covering the metal nanoparticles with a further dielectric layer,
e. optionally, repeating steps c to d one or more times, and
f. providing a second electrode over the further dielectric layer;
wherein a concentration of the metal nanoparticles within each layer of metal nanoparticles is from 0.05 to 1.5 times a percolation threshold, preferably from 0.1 to 1.3 times, more preferably from 0.5 to 1.2 times, yet more preferably from 0.9 to 1.1 times. In embodiments, an area concentration below the percolation threshold, e.g. from 0.05 to 0.99 times the percolation threshold, such as from 0.90 to 0.99 times the percolation threshold, may be preferred.

For instance, if the percolation threshold is determined to be equal to an concentration of 100 (arbitrary units), a concentration of the metal nanoparticles within each layer of metal nanoparticles of from 0.05 to 1.5 times the percolation threshold would correspond to a concentration of from 5 to 150 (arbitrary units).

As another example, if the percolation threshold is determined to be equal to a concentration of 2.00 at%, a concentration of the metal nanoparticles within each layer of metal nanoparticles of from 0.05 to 1.5 times the percolation threshold would correspond to a concentration of from 0.01 to 3.00 at%.

The capacitor of the present invention may typically be a metal-insulator-metal (MIM) capacitor. In embodiments, the first and/or second electrode may be layers. In embodiments, the first and/or second electrode may comprise a metal, e.g. titanium nitride. In embodiments, the plurality of dielectric layers (i.e. the first dielectric layer and the one or more further dielectric layers) and the metal nanoparticles therebetween my form an insulator layer. In embodiments, the capacitor may be a nanoscale structure; the capacitor may, for example, have a total thickness of from 10 to 200 nm, preferably from 20 to 100 nm. In embodiments, a distance (t) between the first electrode and the second electrode (corresponding to an insulator layer thickness) may be from 2 to 10 nm, preferably from 3 to 5 nm. The capacitor may, for example, be a capacitor in a semiconductor device, e.g. a memory device such as a dynamic random-access memory (DRAM) device.

In embodiments, any of the first and further dielectric layers may comprise or consist of a dielectric material having a bandgap of at least 5 eV, preferably at least 5.5 eV, yet more preferably at least 6 eV.

In embodiments, the first and further dielectric layers may each comprise or consist of a dielectric material having a bandgap of at least 5 eV, preferably at least 5.5 eV, yet more preferably at least 6 eV. Preferably, the first and further dielectric layers may each consist of a dielectric material having a bandgap of at least 5 eV, preferably at least 5.5 eV. High bandgap dielectrics are advantageously useful for achieving a low leakage current, even for a very thin insulator layers (e.g. 5 nm or less). In embodiments, any (e.g. all) of the first and further dielectric layers may comprise or consist of a ceramic dielectric material. In embodiments, the ceramic dielectric material may have a dielectric constant of 10 or higher, preferably 15 or higher, yet more preferably 30 or higher. In embodiments, the ceramic dielectric material may comprise or consist of hafnium oxide, lanthanum oxide, praseodymium oxide, lutetium oxide, magnesium oxide or strontium oxide, preferably hafnium oxide.

In embodiments, step b of providing the first dielectric layer over the first electrode may comprise conformally depositing the first dielectric layer over the first electrode. In embodiments, step d of completely covering the metal nanoparticles with a further dielectric layer may comprise conformally depositing the further dielectric layer over the metal nanoparticles. In embodiments, the first and further dielectric layers in steps b, d, and e, may be provided by a conformal deposition technique, preferably atomic layer deposition. Atomic layer deposition advantageously allows conformal layers of the deposited material to be formed, and this even when the dimensions involved are relatively small (e.g. 10 nm or less, or 5 nm or less). These dimensions may, for example, comprise the deposited layer thickness and/or the dimensions of any gaps that might need to be filled in the underlying layer by the deposited material. A conformal deposition technique prevents that air bubbles remain in the insulator layer. In embodiments, the first dielectric layer may have a thickness of at least 1 nm, preferably at least 1.5 nm. In embodiments, the further dielectric layer which is in contact with the second electrode may have a thickness of at least 1 nm, preferably at least 1.5 nm. In embodiments, each further dielectric layer which is not in contact with the second electrode may have a thickness of at least 0.1 nm, such as 0.5 nm.

It was surprisingly found within the present invention that the method of the first aspect, i.e. wherein a layer of metal nanoparticles (having a concentration within the specified range) is formed on a first dielectric layer and subsequently covered by a further dielectric layer (optionally repeating these steps), allows an advantageous metal-dielectric composite to be formed. The obtained metal-dielectric composite is typically characterized by having a relatively high to very high dielectric constant. In embodiments, the dielectric constant may, for example, be at least 40 or more, preferably 50 or more, yet more preferably 60 or more. Even a dielectric constant as high as 100 or more, such as 1000 or more or 10000 or more, may be achieved. Without being bound by theory, this feature of the obtained metal-dielectric composite can be attributed to the effect that the dielectric constant of the metal-dielectric composite diverges when the metal nanoparticle concentration nears its percolation threshold. This effect has for example been described by Mukherjee et al. (2014) for a RuO₂/CaCu₃Ti₄O₁₂ composite (MUKHERJEE, Rupam; LAWES, Gavin; NADGORNY, Boris. Enhancement of high dielectric permittivity in CaCu3Ti4O12/RuO2 composites in the vicinity of the percolation threshold. Applied Physics Letters, 2014, 105.7: 072901).

A further benefit of the obtained metal-dielectric composite is that the dielectric layers provide an electrical insolation of the layers of metal nanoparticles, both with respect to the electrodes as well as between layers of metal nanoparticles. The electrical isolation advantageously reduces the risk of electrical shorts occurring between the first and second electrode, thus keeping the leakage current low. These shorts could, for example, arise when a plurality of metal nanoparticles end up chaining in such a way as to form a conductive path between the first and second electrode. An alternative kind of electrical short could also occur when the metal nanoparticles chain in such a way as to form a partial conductive path between the first and second electrode, thereby lowering an effective tunnel barrier between said electrodes and increasing the leakage current. In embodiments, a minimum distance (d) between the metal nanoparticles and each of the first or second electrode may be at least 1 nm, preferably at least 1.5 nm. In embodiments, the layers of metal nanoparticles may be oriented parallel to the first and second electrode.

In embodiments, the method may be performed in such a way that a substrate on which the capacitor is formed is not damaged. Particularly in the formation of semiconductor devices, a common constraint is the available thermal budget. The limits on the available thermal budget may further rise when the capacitor is not formed at the start of the formation process, but the substrate instead already comprises elements for other semiconductor structures. In embodiments, the method may be performed at a temperature below 1000 °C, preferably below 500 °C, yet more preferably below 200 °C.

In embodiments, the metal nanoparticles may comprise a platinide (i.e. an element selected from Ru, Rh, Pd, Os, Ir, and Pt). In embodiments, the metal nanoparticles may be made of the platinide (i.e. of Ru, Rh, Pd, Os, Ir, or Pt) or of ruthenium oxide. In preferred embodiments, the metal nanoparticles may be made of ruthenium or ruthenium oxide. Metal nanoparticles of platinides and platinide compounds can advantageously be formed using atomic layer deposition (e.g. in situ), and their growth may advantageously be characterized by a relatively long incubation phase (cf. infra). In embodiments, the atomic percentage of the metal nanoparticles within each assembly consisting of a layer of metal nanoparticles (as provided in step c) and a further dielectric layer (as provided in step d) may be from 0.1 % to 10%, preferably from 0.1 % to 5%, yet more preferably from 0.1 to 2%. Such values can be determined for instance by a) measuring the concentration Cₙ in at/cm² corresponding to one or more deposition cycle(s) for the nanoparticles; b) measuring the concentration C_{d} in at/cm² corresponding to one or more deposition cycle(s) for the further dielectric layer; and calculating Nₙ*Cₙ/(Nₙ*Cₙ+N_{d}*C_{d}) wherein Nn and Nd are the number of deposition cycles for the nanoparticles and the further dielectric respectively. In embodiments, each layer of metal nanoparticles may have a thickness of from 0.05 nm to 0.5 nm, e.g. 0.1 nm. In embodiments, step e may comprise repeating steps c to d from 1 to 10 times, preferably from 1 to 5 times, yet more preferably from 1 to 3 times. In embodiments, the capacitor may count from 1 to 11 layers of metal nanoparticles, preferably from 1 to 6, yet more preferably from 1 to 4, and may count from 1 to 11 further dielectric layers preferably from 1 to 6, yet more preferably from 1 to 4.

In preferred embodiments, the layers of metal nanoparticles in step c and e may be provided by atomic layer deposition. In embodiments, the atomic layer deposition may comprise one or more cycles of exposing the dielectric layer (i.e. a first or further dielectric layer) to a first precursor and subsequently exposing the dielectric layer to a second precursor, optionally further comprising purging the first precursor before exposure to the second precursor and/or purging the second precursor at the end of the cycle. In embodiments, the one or more cycles may amount to 1 to 20 cycles, preferably from 1 to 15 cycles, such as from 1 to 10 cycles or from 1 to 5 cycles. Atomic layer deposition advantageously allows the characteristics of the formed nanoparticles, such as their size, to be well controlled.

In embodiments, the method may further comprise a step b', between step b and step c, of:
b'. providing an auxiliary layer over the first dielectric layer, the auxiliary layer being of such a nature that an incubation growth phase of the metal nanoparticles grown thereon is longer than what an incubation growth phase would be for the nanoparticles if they were grown on the first dielectric layer.
In embodiments, step e may comprise repeating steps b' to d one or more times. It was further surprisingly found within the present invention that different phases may be distinguished in the growth of metal nanoparticles by atomic layer deposition. More particularly, the growth may start with an incubation growth phase followed by a further growth phase. The metal nanoparticle growth rate is typically lower during the incubation growth phase (e.g. about 0.01 nm/cycle) than during the further growth phase (e.g. about 0.05 nm/cycle). Furthermore, the metal nanoparticle growth during the incubation phase typically occurs predominantly perpendicular to the substrate; for example, yielding nanoparticles with a more prolate shape. Conversely, the metal nanoparticle growth during the further growth phase typically occurs predominantly parallel to the substrate (i.e. before the metal nanoparticles merge together into a monolithic structure); for example, rendering the nanoparticles progressively more oblate in shape. Growing the metal nanoparticles in the incubation phase may thus have a twofold advantage for the present invention. First, the lower growth rate allows the growth to be more finely controlled (e.g. in terms of particle size and/or area concentration). Second, a more prolate shape of the nanoparticles allows the nanoparticle layer to be made somewhat thicker before the desired concentration is reached; while said concentration is already quickly surpassed for relatively thin layers of oblate nanoparticles. It was found that the transition from the incubation phase to the further growth phase depends on the material combination, and might, for instance, relate to the wetting affinity of the nanoparticles with respect to the underlying surface. For example, the incubation phase of Ru nanoparticles was found to be longer on strontium oxide than on hafnium oxide. The dielectric layer (i.e. a first or further dielectric layer) may therefore be covered with a thin auxiliary layer prior to growing the metal nanoparticles thereon, such as to advantageously prolong the incubation growth phase of the nanoparticles. Akin to the dielectric layers, the auxiliary layer may preferably have a relatively high dielectric constant and/or a relatively large bandgap, such that the combined dielectric constant and bandgap of the dielectric layers and auxiliary layers is not drastically reduced. Nevertheless, the auxiliary layer may typically have a lower dielectric constant and/or a smaller bandgap than the dielectric layer, otherwise one could typically use the material of the auxiliary layer as the dielectric material of the dielectric layer. In embodiments, the auxiliary layer may comprise a dielectric material having a bandgap of at least 4 eV, preferably at least 4.5 eV, yet more preferably at least 5 eV. In embodiments, the auxiliary material may be a ceramic material. In embodiments, the dielectric material may have a dielectric constant of 15 or higher, preferably 25 or higher, yet more preferably 35 or higher. In embodiments, the auxiliary layer may comprise strontium oxide. In embodiments, the metal nanoparticles may comprise ruthenium or ruthenium oxide, the dielectric layer may comprise hafnium oxide, lanthanum oxide, lutetium oxide, praseodymium oxide, zirconium oxide and the auxiliary layer may comprise strontium oxide or magnesium oxide.

In embodiments, the method may further comprise a step g of annealing the capacitor obtained after step f. If annealing is performed, and if the atomic percentage of the metal nanoparticles within each assembly consisting of a layer of metal nanoparticles (as provided in step c) and a further dielectric layer (as provided in step d) is from 0.1 % to 10%, preferably from 0.1 % to 5%, yet more preferably from 0.1 to 2%, the concentration of metal nanoparticles will typically be in a suitable window around the percolation threshold which is favourable for obtaining a high dielectric constant.

When annealing is performed, the first aspect of the present invention may therefore be formulated alternatively as follow:
A method for making a capacitor, comprising:
   a. providing a first electrode,
   b. providing a first dielectric layer over the first electrode,
   c. providing a layer of metal nanoparticles over the first dielectric layer,
   d. completely covering the metal nanoparticles with a further dielectric layer,
   e. optionally, repeating steps c to d one or more times, and
   f. providing a second electrode over the further dielectric layer, thereby forming a capacitor,
   g. annealing the capacitor obtained in step f;
   wherein the atomic percentage of the metal nanoparticles within each assembly consisting of a layer of metal nanoparticles (as provided in step c) and a further dielectric layer (as provided in step d) is from 0.1 % to 10%, preferably from 0.1 % to 5%, yet more preferably from 0.1 to 2%,

In embodiments, any aspect of any embodiment of the first aspect may independently be as correspondingly described for any embodiment of any other aspect.

In a second aspect, the present invention relates to a method for forming a memory device comprising making a capacitor by the method according to any embodiment of the first aspect.

In embodiments, the memory device may be a semiconductor device. In embodiments, the memory device may be a dynamic random-access memory (DRAM) device.

In embodiments, any aspect of any embodiment of the second aspect may independently be as correspondingly described for any embodiment of any other aspect.

In a third aspect, the present invention relates to a capacitor, comprising:
i. a first electrode,
ii. a first dielectric layer over the first electrode,
iii. one or more composite layers on top of each other over the first dielectric layer, each composite layer comprising:
   - a layer of metal nanoparticles obtained by growing them on the layer directly underlying them,
   - a further dielectric layer completely covering the metal nanoparticles, and
iv. a second electrode over the one or more composite layers;
wherein a concentration of the metal nanoparticles within each layer of metal nanoparticles is from 0.05 to 1.5 times a percolation threshold, preferably from 0.1 to 1.3 times, more preferably from 0.5 to 1.2 times, yet more preferably from 0.9 to 1.1 times, and most preferably from 0.9 to 0.99 times.

In other words, the third aspect of the present invention relates to a capacitor, comprising:
i. a first electrode,
ii. a first dielectric layer over the first electrode,
iii. one or more composite layers on top of each other over the first dielectric layer, each composite layer comprising:
   - a layer of metal nanoparticles present on the layer directly underlying them,
   - a further dielectric layer completely covering the metal nanoparticles, and
iv. a second electrode over the one or more composite layers;
wherein a concentration of the metal nanoparticles within each layer of metal nanoparticles is from 0.05 to 1.5 times a percolation threshold, preferably from 0.1 to 1.3 times, more preferably from 0.5 to 1.2 times, yet more preferably from 0.9 to 1.1 times, and most preferably from 0.90 to 0.99 times.

In embodiments, a concentration below the percolation threshold, e.g. from 0.05 to 0.99 times the percolation threshold, may be preferred. This is advantageous as it limits excessive leakage.

In embodiments, a distance (t) between the first electrode and the second electrode may be from 2 to 10 nm, preferably from 3 to 5 nm.

In practice, a distinction between the first dielectric layer and the one or more further dielectric layers may in some embodiments be difficult to perceive, or they may even be indistinguishable. The capacitor may thus appear as a first and second electrode comprising therebetween a single composite structure of a monolithic dielectric layer engulfing one or more layers of metal nanoparticles.

In embodiments, the capacitor may further comprise one or more auxiliary layers directly underlying one or more of the layers of metal nanoparticles.

In embodiments, any aspect of any embodiment of the third aspect may independently be as correspondingly described for any embodiment of any other aspect.

In a fourth aspect, the present invention relates to a memory device comprising a capacitor according to any embodiment of the third aspect.

In embodiments, any aspect of any embodiment of the fourth aspect may independently be as correspondingly described for any embodiment of any other aspect.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: capacitor comprising a single layer of metal nanoparticles

We now refer to Fig. 1. A 40 nm thick TiN first electrode (110) is deposited on a substrate (e.g. a Si wafer, not depicted) by first depositing a 10 nm thick TiN layer using a physical vapour deposition and subsequently depositing a 30 nm thick TiN layer by atomic layer deposition (ALD). Subsequently, an HfO₂ first dielectric layer (210) of thickness (d) equal to 2.5 nm is deposited on the first electrode (110) by ALD. Then a layer (300) of Ru metal nanoparticles (310) is formed on the first dielectric layer (210) by ALD. The layer (300) of metal nanoparticles (310) has a concentration between 0.05 and 1.5 times the percolation threshold of the nanoparticles (310); preferably a concentration close to that of the percolation threshold, such as 0.9 times the percolation threshold. This layer (300) of metal nanoparticles (310) is further covered by a 2.5 nm thick HfO₂ further dielectric layer (220) using ALD. The distance (d') depicted in Fig. 1 correspond to the distance between the nanoparticles and the electrode. Finally, a 40 nm thick TiN second electrode (120) is deposited on the further dielectric layer (220) by ALD.

### Example 2: capacitor comprising a plurality of layers of metal nanoparticles

We now refer to Fig. 2. A 40 nm thick TiN first electrode (110) is deposited on a substrate (e.g. a Si wafer, not depicted) by first depositing a 10 nm thick TiN layer using a physical vapour deposition and subsequently depositing a 30 nm thick TiN layer by ALD. Subsequently, a 1.5 nm thick HfO₂ first dielectric layer (210) is deposited on the first electrode (110) by ALD. Then a layer (300) of Ru metal nanoparticles (310) is formed on the first dielectric layer (210) by ALD. The layer (300) of metal nanoparticles (310) has a concentration between 0.05 and 1.5 times the percolation threshold of the nanoparticles (310); preferably a concentration close to that of the percolation threshold, such as 0.9 times the percolation threshold. This layer (300) of metal nanoparticles (310) is further covered by a 1 nm thick HfO₂ further dielectric layer (220) using ALD. These steps are repeated two more times to form a second layer (300) of metal nanoparticles (310) covered by a 1 nm thick second HfO₂ further dielectric layer (220), as well as a third layer (300) of metal nanoparticles (310) covered by a 1.5 nm thick third HfO₂ further dielectric layer (220). Finally, a 40 nm thick TiN second electrode (120) is deposited on the third further dielectric layer (220) by ALD.

### Example 3: capacitor comprising auxiliary layers

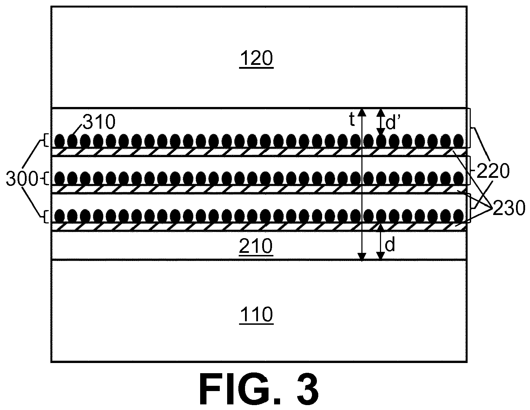

We now refer to Fig. 3. A 40 nm thick TiN first electrode (110) is deposited on a substrate (e.g. a Si wafer, not depicted) by first depositing a 10 nm thick TiN layer using a physical vapour deposition and subsequently depositing a 30 nm thick TiN layer by ALD. Subsequently, a 1.5 nm thick HfO₂ first dielectric layer (210) is deposited on the first electrode (110) by ALD. Prior to depositing forming metal nanoparticles, the first dielectric layer (210) is covered with a 0.5 nm thick SrO auxiliary layer (230) by ALD, which enhances the incubation growth phase of the nanoparticles. A layer (300) of Ru metal nanoparticles (310) is then formed by ALD on this auxiliary layer (230). The layer (300) of metal nanoparticles (310) has a concentration between 0.05 and 1.5 times the percolation threshold of the nanoparticles; preferably a concentration close to that of the percolation threshold, such as 0.9 times the percolation threshold. This layer (300) of metal nanoparticles (310) is further covered by a 1 nm thick HfO₂ further dielectric layer (220) using ALD. These steps are repeated two more times to form a second layer (300) of metal nanoparticles (310) on a 0.5 nm thick second auxiliary layer (230) and covered by a 1 nm thick second HfO₂ further dielectric layer (220), as well as a third layer (300) of metal nanoparticles (310) on a 0.5 nm thick third auxiliary layer (230) and covered by a 1.5 nm thick third HfO₂ further dielectric layer (220). Finally, a 40 nm thick TiN second electrode (120) is deposited on the third further dielectric layer (220) by ALD.

It is clear that the use of an auxiliary layer can also be combined with example 1, so as to obtain a single layer of metal nanoparticles on an auxiliary layer. Furthermore, in some embodiments, there may be a desire to grow some layers of metal nanoparticles on an auxiliary layer, while others are grown directly on a dielectric layer; example 3 can be straightforwardly adapted to achieve this.

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for making a capacitor, comprising:
a. providing a first electrode (110),
b. providing a first dielectric layer (210) over the first electrode (110),
c. providing a layer (300) of metal nanoparticles (310) over the first dielectric layer (210),
d. completely covering the metal nanoparticles (310) with a further dielectric layer (220),
e. optionally, repeating steps c to d one or more times, and
f. providing a second electrode (120) over the further dielectric layer (220);
wherein a concentration of the metal nanoparticles (310) within each layer (300) of metal nanoparticles (310) is from 0.05 to 1.5 times a percolation threshold, preferably from 0.1 to 1.3 times, more preferably from 0.5 to 1.2 times, yet most preferably from 0.9 to 1.1 times, and most preferably from 0.90 to 0.99 times.

2. The method according to claim 1, wherein step b of providing the first dielectric layer (210) over the first electrode (110) comprises conformally depositing the first dielectric layer (210) over the first electrode (110).

3. The method according to claim 1 or 2, wherein the first and further dielectric layers (220) comprise a dielectric material having a bandgap of at least 5 eV, preferably at least 5.5 eV, yet more preferably at least 6 eV.

4. The method according to any of the previous claims, wherein the first and further dielectric layers (220) in steps b, d, and e, are provided by atomic layer deposition.

5. The method according to any of the previous claims, wherein the layers of metal nanoparticles in steps c and e are provided by atomic layer deposition.

6. The method according to any of the previous claims, wherein the metal nanoparticles (310) are made of Ru, RuO₂, Rh, Pd, Os, Ir, or Pt.

7. The method according to any of the previous claims, wherein a distance (t) between the first electrode (110) and the second electrode (120) is from 2 to 10 nm, preferably from 3 to 5 nm.

8. The method according to any of the previous claims, wherein a distance (d) between the metal nanoparticles (310) and each of the first and second electrode (120) is at least 1 nm, preferably at least 1.5 nm.

9. The method according to any of the previous claims, further comprising a step b', between step b and steps c, of:
b'. providing an auxiliary layer (230) over the first dielectric layer (210), the auxiliary layer (230) being of such a nature that an incubation growth phase of the metal nanoparticles (310) grown thereon is longer than what an incubation growth phase would be for the nanoparticles if they were grown on the first dielectric layer (210).

10. The method according to claim 9, wherein step e comprises repeating step b' to d one or more times.

11. The method according to any of the previous claims, wherein the dielectric material comprises hafnium oxide, lanthanum oxide, lutetium oxide, praseodymium oxide, zirconium oxide, magnesium oxide or strontium oxide.

12. The method according to any of the previous claims, further comprising a step g of annealing the capacitor obtained after step f.

13. A method for forming a memory device comprising making a capacitor by the method according to any one of claims 1 to 12.

14. A capacitor, comprising:
i. a first electrode (110),
ii. a first dielectric layer (210) over the first electrode (110),
iii. one or more composite layers on top of each other over the first dielectric layer (210), each composite layer comprising:
- a layer (300) of metal nanoparticles (310) obtained by growing them on the layer directly underlying them,
- a further dielectric layer (220) completely covering the metal nanoparticles (310), and
iv. a second electrode (120) over the one or more composite layers;
wherein a concentration of the metal nanoparticles (310) within each layer (300) of metal nanoparticles (310) is from 0.05 to 1.5 times a percolation threshold, preferably from 0.1 to 1.3 times, more preferably from 0.5 to 1.2 times, yet more preferably from 0.9 to 1.1 times, and most preferably from 0.90 to 0.99 times.

15. A memory device comprising a capacitor according to claim 14.
